# EUROPEAN PATENT APPLICATION

(11) **EP 4 455 925 A1**
(43) Date of publication of application: **30.10.2024**
(21) Application number: 23170064.2
(22) Date of filing: 26.04.2023
(51) Int. Cl.: G06F 30/13, G06F 16/26, G06F 16/29

(54) **GRID-BASED ANALYSIS OF ENVIRONMENTS**

(71) Applicant: AFRY Deutschland GmbH, 68161 Mannheim (DE)
(72) Inventor: KUNZ, Matthias, 50321 Brühl (DE); HERMANN, Felix, 04107 Leipzig (DE); MAX, Paul-Christian, 04315 Leipzig (DE)
(74) Representative: Valvoda, Jakob

(57) **Abstract**

The present disclosure refers to a method, comprising providing a grid including a plurality of grid cells, each grid cell designating an area of a surface, obtaining one or more models of one or more structures, each structure being positioned in at least one of the areas designated by the grid cells of the grid, identifying properties of components of the one or more structures in each of the one or more models, retrieving values for the properties from a data source, for each grid cell, identifying components of the one or more structures in the one or more models positioned in the respective grid cell, retrieving the properties of the identified components, and calculating one or more parameters for the respective grid cell using the retrieved properties and the corresponding values, generating one or more combined representations of the one or more parameters for the grid cells, rendering a representation of the surface and of the one or more combined representations, each positioned at the respective grid cell on the surface, and enabling interaction with at least a part of the one or more combined representations of the one or more parameters. Furthermore, a device and a system are described.

## Description

### TECHNICAL FIELD

The disclosure relates to the analysis of environments. Preferably, an environment may comprise structures. Parameters of the environment may be determined and analyzed based on a grid that designates areas in the environment. In particular, the disclosure relates to a method for analyzing environments, a corresponding computer-readable medium, a device, and a system.

### BACKGROUND

Various engineering fields require the analysis of environments with respect to properties of structures within the environment. Environments may include small-scale environments such as those used in microelectronics, medical imaging, or microfabrication. Environments may be analyzed to plan the production of microprocessors, memory chips, or sensors. Medical images can be analyzed to identify small areas of disease or injury and plan treatment. Large-scale environments are typically analyzed using geographic information systems (GIS) techniques.

GIS are systems designed to capture, analyze, and present spatial or geographic data. GIS is typically used to map and visualize environmental data. It can be used in a variety of fields, including urban planning, natural resource management, transportation, and demographics. For data analysis, GIS can be used to analyze spatial data, such as calculating distances, areas, and overlaps, as well as performing analysis tasks such as spatial statistics or spatial modeling. GIS can also be used to support planning processes such as site selection, impact assessment, and emergency response planning, to name a few.

Various systems can be used to visualize map data of environments, which can be combined with models related to structures within the environment. This provides an overview of individual structures for selected criteria. However, this is typically limited to static data of the map or structure and does not allow a more detailed and combined analysis of the provided data.

Structural data can be made available as models. For example, models can be retrieved from Building Information Modeling (BIM) systems. BIM systems are used to digitally represent the physical and functional characteristics of buildings or infrastructure. It can be used in the planning, design, construction, and maintenance of buildings and other structures. BIM systems allow engineers to process building data and information throughout the building lifecycle, from initial concept to demolition.

Although BIM systems provide insight into the parameters of structures throughout their lifecycle, the data is focused on the structure and is not related to other environmental data.

### SUMMARY

Thus, there is a need in the art for further optimizing analysis approaches for environments that include structures.

The problem is solved by a method, a computer-readable medium, a device, and a system according to the independent claims. Preferred embodiments are defined in the dependent claims.

A first aspect of the disclosure defines a method comprising providing a grid including a plurality of grid cells, each grid cell designating an area of a surface; obtaining one or more models of one or more structures, each structure being positioned in at least one of the areas designated by the grid cells of the grid; identifying properties of components of the one or more structures in each of the one or more models; retrieving values for the properties from a data source; for each grid cell, identifying components of the one or more structures in the one or more models positioned in the respective grid cell, retrieving the properties of the identified components, and calculating one or more parameters for the respective grid cell using the retrieved properties and the corresponding values; generating one or more combined representations of the one or more parameters for the grid cells; rendering a representation of the surface and of the one or more combined representations, each positioned at the respective grid cell on the surface; and enabling interaction with at least a part of the one or more combined representations of the one or more parameters.

The method may be a computer-implemented method. In particular, the method may be executed by one or more processing units on one or more computing devices that may form a system. At least one device may further implement the data source. Thus, the method may be executed in the system including a plurality of the one or more computing devices, which may be connected, for example, via at least one network or interconnect. At least one of the one or more computing devices may access the data source. Further, the at least one device or another device of the one or more devices may render the representation of the surface and the combined representations of the parameters.

The approach enables analysis and exploitation of environments from a technical perspective by rendering interactive representations of technical parameters of the environment and of structures within the environment. The properties of the structures and the influence of the environment on the structures are processed and analyzed based on the surface grid. This shifts the focus from individual properties of structures to a global technical perspective of the environment. Individual properties of components are no longer analyzed and processed with respect to individual structures. Instead, the structures are embedded in the environment and processed and analyzed with respect to the environment based on the surface grid. The representations may also allow for direct adaptation of parameters or properties, e.g. to provide an improved placement of (physical) structures within the (physical) environment from an engineering perspective, or to plan modifications to the environment that result in improved technical properties of the structures or the environment.

The (surface) grid can be defined as one or more arrays of grid cells. Each grid cell can designate a corresponding area on the surface. Each region may be either empty or contain at least a portion of the structures or other components of the environment.

For example, the grid can be regular. A regular 2D grid can be an array of squares or rectangles representing the grid cells. Similarly, a regular 3D grid can represent arrays of shapes, including cubes or rectangular boxes, or any other hexahedron or box, that represent the grid cells. The grid can represent one or more arrays of polyhedra that can represent the grid cells. The regular grid may have a grid spacing or a grid distance that may correspond to the size of the grid cells. Additionally or alternatively, the grid may be at least partially irregular. The spacing of the irregular grid may be based at least in part on the models of the structures. The grid may be adapted to the boundaries of components of the structures in the environment. Thus, the grid may be at least partially regular or irregular within or outside the boundaries of components of the structures.

The one or more models may be three-dimensional (3D) models. Each model may correspond to and/or represent one, two, three or more of the one or more structures. Each structure may comprise one or more components. A shape of the structure and/or the one or more components may be represented as geometry in the model. The geometry may be represented by geometric primitives or shapes, such as triangles, which may be further arranged into groups or graphic elements. Each group of geometric primitives or graphic element in the model may represent, for example, a component of the structure. Thus, components of the structure can be represented in the model as parts of the geometry. The model may further specify the properties of the components of the represented structure(s). The models may be provided on a medium, in a storage, memory or buffer, made available for download from distributed or local storage, or otherwise provided in computing device(s) performing the method.

The model can be understood as a digital or virtual representation of the structure, its components and their (physical) properties.

Each structure may include one or more components with associated properties, which may be specified or defined by the respective model. The properties can be retrieved from the model(s), processed, and used to access the data source to retrieve corresponding values. For example, each property may have a corresponding value defined in the data source. Thus, the models can define physical properties of the components that are linked to values provided by another data source. This allows the properties to be analyzed and processed in terms of different physical interpretations and estimates of the properties without having to change the underlying models.

The combined representations reflect the parameters for the individual grid cells. If a grid cell does not include (parts of) a structure, a corresponding grid cell may not be associated with a combined representation, or the combined representation for the corresponding grid cell may be empty or indicate that the grid cell is empty. The combined representations may represent billboards or other interfaces that allow analysis and exploitation of the calculated parameters, the underlying properties and/or the corresponding values for the respective grid cell. The combined representations may be (combined) 3D representations.

The rendered representation of the surface and the one or more combined representations may be 3D representation(s). The rendered representation may further include representations of the structures. At least the combined representations may be configured as interactive interfaces. A user may interact with at least one of the rendered representation of the surface, the combined representations, or the representations of the structures, for example by using input devices or input interfaces. Each representation, including the representation of the surface, the combined representations, and/or the representations of the structures, may be associated with graphical elements arranged in a scene graph. A scene graph, as used throughout this disclosure, is a general data structure that arranges representations of entities in a graphical scene. The scene graph may include a collection of nodes associated with the representations of the entities and arranged as a directed graph or tree, where each node may have children and a parent node. Typically, nodes without children are referred to as leaf nodes, and nodes with one or more children are also referred to as group nodes. Leaf nodes can reference objects, sprites, sounds, lights, or anything else that might be considered for rendering. Typically, an operation performed on a parent node automatically propagates to its child nodes and eventually to the leaf nodes. Each node in the scene graph can include additional parameters, such as a transformation matrix, that are applied during processing of the node. For example, the transformation matrix may define a local transformation of the node with respect to the parent node.

The graphical elements or groups can include one or more geometric primitives or shapes, such as spheres, cylinders, cubes or boxes, toroids, pyramids, triangular meshes, point clouds, and others.

To render the representations associated with the graphical elements in the scene graph, a viewing perspective on the scene graph may be determined in response to user input, and the scene graph may be rendered. The user input may indicate, for example, a desired translation or rotation of the entire scene, including the environment and structures, a representation, a subset or component thereof, or of graphical elements associated with the representations. The transformation matrix of one or more group nodes and/or one or more leaf nodes may be updated to reflect the desired translation and/or rotation of respective graphical elements. The scene graph may be traversed and the final scene may be rendered from the desired viewing perspective. It is to be understood that the viewing perspective may be adjusted at any time in response to user input, and the representations are rendered based on the adjusted viewing perspective.

The method enables advantageous and optimized analysis and exploitation of environments to determine improved settings of the environment with respect to structures in the environment based on physical properties of the structures and their interaction with the environment.

According to a particularly preferred embodiment, the method further comprises retrieving the one or more 3D models from a Building Information Modeling system. Building Information Modeling (BIM) is a digital representation of the physical and functional characteristics of a building, structure, or environment, including the geometry, properties, and relationships between components of the building, structure, or environment. A BIM system typically stores 3D models of the design, construction, and operation of a structure (or building). By retrieving 3D models from the BIM system, the method can use the data and information stored in the BIM to improve the accuracy and efficiency of a 3D representation, making it possible to more fully visualize and analyze the design, construction, and maintenance of a structure (or building). BIM technology is widely used in the architecture, engineering, and construction (AEC) industry to enhance collaboration, improve communication, and reduce the risk of errors and omissions.

In a preferred embodiment, the values include one or more of carbon footprint of manufacture, carbon footprint of transportation, or carbon footprint of construction of structures. The values may also relate to any of the construction or deconstruction characteristics, re- or up-scaling capabilities, and the like, to name a few. Preferably, the values are sustainability values. The values for the retrieved properties are used to calculate the one or more parameters for the respective grid cells. Accordingly, the values may be numerical values which may be, for example, multiplied by a volume of the corresponding component or structure in the grid cell and/or aggregated and/or otherwise processed in a formula, procedure or algorithm configured to calculate the parameters for the respective grid cell. Preferably, the one or more parameters define one or more of a spatial-structural impact, an engineering impact, and an environmental impact of a route and/or structure in the respective grid cell.

In one embodiment, the method further comprises determining whether a model spans a plurality of grid cells, and if the model spans a plurality of grid cells, segmenting the model into partial models along boundaries of the grid cells, and determining the properties of components of the one or more structures in the partial models.

The grid can define a segmentation of the environment and of the structures placed in the environment into respective areas of the grid. When a structure spans multiple areas of the grid, the grid can be used to segment the structure so that each segment of the structure can be associated with a corresponding area (or corresponding grid cell of the grid). For example, the grid may be a 2D grid and the segmentation may be a vertical segmentation of the structure(s) based on the boundaries of the 2D grid cells. The segments may be generated by any suitable segmentation, fragmentation, decomposition, or cutting technique using equidistant, regular, or irregular grids. The segmentation may be performed automatically on the computing device(s) performing the method. The segments may constitute the partial models.

Accordingly, for each grid cell, the segments of the components of the structures in the grid cell may be identified in order to retrieve the corresponding properties from the (partial) models. For example, the model may include properties for different components of the represented structure. Based on the segmentation according to the grid cells, the number of properties can be reduced to the actual components within the grid cell. The retrieved properties and their corresponding values are used to calculate the parameters for the grid cell. Accordingly, the parameters reflect and summarize the properties and their values for the parts of the structures (segments) located in each individual grid cell.

In a further embodiment, the properties include a volume of the corresponding component for each grid cell. A (segmented) component in a grid cell may correspond to a physical part of the structure, which may have a volume in the grid cell. Preferably, the properties (further) include material properties of components of the structure. Thus, the properties may include a volume of the component in the grid cell and respective material properties. This may allow for determination of a material quantity required for the (segmented) component in the grid cell.

In a particularly preferred embodiment, the properties include one or more IDs of materials of components of the structure, and the method further comprises using the one or more IDs to retrieve the values from the data source. The term ID may be used throughout this disclosure to refer to an identification, which may be a textual or numerical designation, or a link or pointer to another textual or numerical designation, e.g., of the material. For example, the ID may be a text description of the material or a numerical identifier. Properties of a structure's components may include various types of information that describe the characteristics of the components. The (material) IDs could serve as unique identifiers for the materials used in the components and could be used to retrieve values associated with the materials from the data source. By using the one or more IDs to retrieve values from the data source, the method can obtain information such as the properties, characteristics, and specifications of the materials, allowing the device to generate a more accurate and detailed representation of the structure, and a more accurate and detailed analysis of the parameters of the grid cells. For example, the data source could contain information (and respective values) on composition, compounds, strength, weight, and/or thermal properties of various materials, to name a few, and the method could use the IDs to retrieve this information and values for use in a structural analysis or for visualization. By using the IDs to retrieve values from the data source, the method can ensure that the representation is consistent with the data and information stored in the data source, reducing the risk of errors and omissions and improving the overall accuracy of the representation. Material IDs could be used to efficiently retrieve material property values from the data source.

For example, queries can be short and include numerical values to query the data source, in order to implement an optimized query mechanism of the data source. Preferably, the data source can be a database. The query mechanism can use the IDs as search criteria to quickly locate the relevant information in the database. This can be achieved using various database optimization techniques, such as indexing, caching, and partitioning. For example, the database could be indexed on the material IDs, allowing the query mechanism to quickly locate the relevant information based on the ID. Additionally, the query mechanism could cache frequently accessed material property values to reduce the number of database accesses and improve the performance of the retrieval process. Partitioning the database based on the material IDs can also help to reduce the time required to retrieve the material property values, as it allows the database to be divided into smaller, more manageable segments, making it easier to locate the relevant information. By implementing these optimization techniques, the IDs can be used to efficiently retrieve the material property values from the database, improving the performance of the method and reducing the time required to generate the representation. Additionally, the optimization techniques can help to ensure that the retrieval process is scalable and can accommodate large amounts of data, allowing the method to continue to perform efficiently as the database grows over time.

Material IDs or material information included in the properties may be linked to values in the data source using a predetermined mapping function. In a preferred embodiment, the material information (or ID) may be a text string that may be automatically generated from information, such as metadata, of the one or more models. The material information may be provided to a machine learning system, which may map the material information to values stored in the data source, such as in a database. Regarding (eco) databases storing environmental impact factors, the machine learning system may automatically assign the environmental impact factors (or respective values or parameters) to any material, process or product defined in the model, even if the respective information is not previously defined in the mapping function. This enables a highly flexible adaptation of the inventive approach to new models.

As mentioned above, the data source can be a database. However, the data source may refer to any software and/or hardware module or component capable of providing data, including the values, in response to a query. This may include a storage or memory module, or a machine learning system or any kind of knowledge base, which may be implemented in hardware and/or as software module(s).

In one embodiment, the one or more structures are interconnected via one or more routes on the surface, and the method further comprises retrieving values for the one or more routes from the data source; for each grid cell, identifying routes that lead through the respective grid cell, wherein the one or more parameters for the respective grid cell are calculated using the identified routes, the retrieved properties, and the corresponding values. The environment may comprise the one or more routes, and the one or more routes may interconnect at least some of the structures in the environment. For example, a first route may connect two structures. The routes may have properties, and corresponding values for the properties of the routes may be retrieved from the data source. The properties of the routes may, for example, affect the environment or be affected by the environment. The method may be used to analyze and visualize interconnected structures, such as transportation networks, communication networks, or utility networks, located on a surface. These routes can be roads, pipelines, power lines, or any other type of route that connects the structures. By identifying the routes that pass through each grid cell, the method can determine the impact of the routes on the respective grid cell and use this information to calculate one or more parameters for the grid cell. The parameters for the grid cell can include a variety of information, such as the density of the routes, the total length of the routes, the average travel time along the routes, or the total energy consumption along the routes. This information can be used to generate a representation of the interconnected structures, allowing users to visualize and analyze the relationships between the structures and the routes. In addition, the parameters can be used to support a variety of analysis tasks, such as network optimization, risk assessment, or capacity planning. By using the values for the routes, the properties of the structures, and the corresponding values, the method can provide a comprehensive and accurate representation of the interconnected structures and the relationships between them.

According to another embodiment, the method further comprises adjusting a position and/or orientation of at least one structure on the surface, and re-routing at least one of the one or more routes interconnecting the at least one structure. Said re-routing may be based on the new position and/or orientation of the structure. For example, a structure may represent a bridge, tunnel, train station, or other infrastructure component or building, and the course of the route leading to and from the structure may be changed when the position and/or orientation of the structure is changed. The structure may also represent an electronic component on a circuit board. The routes may be re-routed taking into account properties of the surface and/or other routes, such as a surface structure, distance to other routes, and the like. The route may be constrained by, for example, slope, gradient, surface conditions, and the like, to name a few. The adjusted position or orientation of the at least one structure and the new course of the re-routed routes may be used to update the parameters for the respective grid cells. Preferably, the parameters are updated only for grid cells that may be affected by the adjustment and/or re-routing, such as the original grid cells containing the structure and routes at the original position and/or orientation of the structure, and the new grid cells containing the structure at the new position and/or orientation and through which the re-routed routes pass. Accordingly, repositioning and reorienting structures in the environment may result in updated routes.

Preferably, the method further comprises changing a course of two or more routes interconnecting at least one structure and verifying the at least one structure positioned at the changed course of the two or more routes. Changing the course of routes can directly affect the position and orientation of connected structures, which can be adjusted to the nearest or appropriate position and orientation along the changed course of the routes. The adjusted structure may be verified based on surface properties. This may include verifying that the structure can be placed in the new position or orientation. This may also include verifying that the structure is still capable of performing its function, such as bridging a gap or providing an electrical function, which may result in an indication that the structure must either be repositioned/reoriented or adjusted to provide the function in the new position/orientation. For example, a bridge may be extended or modified to bridge a gap in the new position/orientation, or the properties of a semiconductor device may be adjusted to match adjacent devices in the new position/orientation. Similarly, a change in the routing of routes in the environment may result in the repositioning or reorientation of structures. This may eventually lead to adjustments of the structures.

In a preferred embodiment, the method further comprises providing at least one further 3D model of an alternate structure for the at least one structure positioned at the changed course of the two or more routes. The alternate structure may be the same as the adjusted structure that may be required after changing the course of interconnected routes. Thus, the alternative structure may be able to perform the function of the original structure in the new position/orientation. The parameters of the grid cells can be updated. In particular, the grid cells can be analyzed to determine which grid cells contain the modified routes and/or the alternative structure, and for each of these grid cells, components of the alternative structure in the further 3D model and further structures positioned in the respective grid cell (and preferably the modified routes) can be identified, the properties of the identified components (and preferably the modified routes) can be retrieved, and the one or more parameters for the respective grid cell can be calculated/updated using the retrieved properties and the corresponding values. The updated one or more parameters of the grid cells may be used to generate the one or more combined 3D representations of the one or more parameters for the grid cells which are subsequently rendered. It is to be understood that the calculation of the parameters and the generation of the combined representations can be performed for grid cells or representations that are affected by the changed route and/or the adjusted structures. A graphical user interface may allow a user to display a representation of the original configuration with the original route and original structures, and/or a representation of the updated configuration with the new route and alternative structures, and/or an overlay of both configurations, and may allow the user to switch or fade between representations of both configurations.

In another embodiment, the values for the one or more routes include a classification of areas on the surface through which the route leads. Classifications may include one or more of primary areas, urban areas, residential areas, mixed areas, noise barriers, and the like. Routes can affect the environment in various ways. The classification of areas can further affect the calculated parameters for the environment. For example, the length of a route can affect air and greenhouse gas emissions. Route profiles can affect the energy consumption of vehicles such as cars and trains, thus contributing to climate change. In addition, the construction of transportation infrastructure can affect land use, resulting in habitat loss and fragmentation and contributing to deforestation. Transportation infrastructure can affect water quality by altering drainage patterns and causing runoff of pollutants into waterways. Transportation infrastructure can also affect biodiversity by fragmenting habitats and blocking wildlife migration corridors. The volume of traffic and the speed of vehicles on routes can also contribute to noise pollution and negatively affect the well-being of nearby residents.

According to a particularly preferred embodiment, the method further comprises adjusting at least one property of at least one component, retrieving values for the adjusted at least one property, and re-calculating the one or more parameters for grid cells including the at least one component. In addition to adjustments to the routes and placement of structures, adjustments can also be made to the components of the structures. For example, the material properties of the structures and the shapes of the structures can be changed, which can have an effect on the retrieved values or the volume in the respective grid cell. The ability to adjust the properties of structures and the shapes of structures provides a more complete and nuanced view of the interconnected structures, the relationships between them, and their impact on the environment. For example, changes to the material properties of structures, such as the material composition, strength, or stiffness of a bridge or the insulation of a pipeline, can affect the retrieved values or the volume in the corresponding grid cell. Similarly, changes in the shape of structures, such as the shape of a building or the layout of a road network, can also affect the parameters calculated for each grid cell. By incorporating these additional layers of complexity, the method provides a more sophisticated and nuanced view of the interconnected structures, the relationships between them, and their impact on the environment. This allows users to evaluate and compare different scenarios and make more informed decisions about the design and operation of interconnected structures. The ability to customize the properties of both the routes and the structures, as well as the shapes of the structures, provides a powerful and flexible tool for analyzing and visualizing the interconnected structures and the relationships between them. This feature supports real-time scenario analysis and enables users to make informed decisions about the design and operation of the interconnected structures.

According to another embodiment, the method further comprises adjusting a grid size of the grid cells and re-calculating the one or more parameters for the grid cells with the adjusted grid size. If the grid size of a model changes, the volume in each grid cell will change as well. When the grid size is increased (i.e., the grid cells become larger), the area covered by each grid cell increases. If the grid size is decreased (i.e., the grid cells become smaller), the area covered by each grid cell may decrease. It may be important to consider the effect of changing the grid size on the accuracy and performance of the processing. When the grid size is decreased (i.e., the cells become smaller), the processing becomes more computationally intensive and may require more computing resources, but the increased resolution may improve the accuracy of the results, such as the combined plots. However, a smaller grid size also leads to an increased number of combined representations, which may reduce the possibilities for interactive analysis and evaluation of the displayed environment. On the other hand, increasing the grid size may reduce the required computational resources, but may result in a loss of accuracy. An increased grid size may lead to a coarse overview, which in turn may improve the possibilities for interactive analysis and evaluation of the displayed environment. Preferably, the grid size can be adjusted interactively, preferably in real time.

Preferably, the method further comprises, responsive to the interaction with the combined 3D representations, overlaying the rendered 3D representation of the surface and of the one or more combined 3D representations with a representation of the one or more parameters. Throughout this disclosure, the representations may include one or more of the combined representations of the parameters, the representations of the surface, and optionally representations of the models and the routes that can be rendered and displayed. By interacting with one of the displayed representations, for example by using an interaction device or interaction interface, which may be direct, such as a pointing device or touch screen that allows direct touching of the representations, or indirect, such as a mouse, the rendered and displayed representation with which one is interacting may be identified to identify the grid cell and the one or more parameters used to generate the representation. The representation of the one or more parameters may provide further insight into the structure and properties of the one or more parameters. Thus, the rendered and displayed representations may allow identification of areas with potentially interesting or significant technical characteristics that, if potentially adjusted, may have a (large) impact on the environment. In response to interaction, the analysis and evaluation of the area can be further detailed.

According to another embodiment, the method further comprises analyzing the one or more parameters and identifying structures and/or routes with potential for optimization. The analysis may be performed automatically on the computer(s) performing the method. The computer(s) may analyze the structures and/or paths for optimization using algorithms such as linear programming, heuristics, or meta-heuristics. These algorithms take one or more constraints as input and generate solutions that maximize or minimize an objective function. The constraints may include resource constraints, time constraints, cost, efficiency, and other relevant factors. The constraints may be equal to or derived from the one or more parameters. Other parameters, physical properties, or constraints may be used in any combination in the analysis of the one or more parameters of the environment. The analysis may take into account physical properties of the environment, of the structures, and/or of the routes in the environment. The algorithms may also incorporate machine learning techniques to improve performance over time as more data is processed. The results of the analysis can be used to identify areas for improvement and generate recommendations for optimization.

In a preferred embodiment, the method further comprises displaying the rendered 3D representation of the surface and of the one or more combined 3D representations on at least one display. The at least one display may include at least one monitor or projector. The display technology may be 2D displays or 3D displays, such as stereoscopic displays that use two images displayed separately for each eye to create the illusion of depth; autostereoscopic displays that use optical elements or parallax barrier to direct different images to each eye, without the need for special glasses; holographic displays that use laser light to create a three-dimensional image in the air; volumetric displays that use a spatial light modulator or a stack of 2D displays to create 3D images in space; and/or light field displays that use micro-lenses to control the light direction and create the illusion of 3D images, in any combination.

According to another embodiment, the surface is the surface of the earth, and the one or more routes are infrastructure routes. The infrastructure routes may include railways, roads, waterways, bridges, pipelines, or transmission lines, to name a few, in any combination. A computer can analyze one or more parameters to identify areas where infrastructure improvements can be made. For example, a computer can use GIS technology and routing algorithms to determine the optimal placement of infrastructure routes such as railways, roads, waterways, bridges, pipelines, or transmission lines. The algorithms can take into account various factors of the environment that can be reflected in the parameters of the environment, the properties of (components of) the structures, and corresponding values when determining the most efficient routes. These may include terrain, population density, climate, cost, and environmental impact. The results of the analysis can be used to make informed decisions about changes in infrastructure or infrastructure development, leading to improved transportation networks and better access to resources.

In a further embodiment, the method further comprises providing the rendered 3D representation and the parameters in a Geographic Information System. The Geographic Information System (GIS) is a computer-based system for capturing, storing, analyzing, and managing data and associated attributes that are spatially referenced to the earth. By incorporating a 3D representation and associated parameters into the GIS, users can visualize and analyze geographic data in a more interactive and intuitive manner, allowing for more informed decision making. This can be particularly useful in industries such as urban planning, environmental management, and resource exploration, to name a few.

A second aspect of the disclosure defines a device, comprising a display; one or more interfaces; and a processor configured to perform a method according to an embodiment of the first aspect. In particular, the device can be configured to provide a grid including a plurality of grid cells, each grid cell designating an area of a surface; obtain one or more models of one or more structures, each structure being positioned in at least one of the areas designated by the grid cells of the grid; identify properties of components of the one or more structures in each of the one or more models; retrieve values for the properties from a data source; for each grid cell, identify components of the one or more structures in the one or more models positioned in the respective grid cell, retrieve the properties of the identified components, and calculate one or more parameters for the respective grid cell using the retrieved properties and the corresponding values; generate one or more combined representations of the one or more parameters for the grid cells; render a representation of the surface and of the one or more combined representations, each positioned at the respective grid cell on the surface; and enable interaction with at least a part of the one or more combined representations of the one or more parameters.

Preferred embodiments of the device may include software or hardware units configured with dedicated software that may provide the functionality according to processing steps of an embodiment of the present disclosure. The one or more (input) interfaces may be configured to obtain the model(s), retrieve values for properties from the data source, and enable interaction with the rendered representations. The device may further comprise one or more determination or processing units to identify properties of the structures, segment the geometry, and perform the grid-based processing to compute parameters of the grid cells. The device may further comprise a graphics unit for generating the various (3D) representations and for rendering the representations on the display. The device may further comprise a calculator configured to calculate the property and a verifier configured to verify the property. The (hardware) units may be coupled via an interconnect, such as a bus or a network. The (hardware) units may be implemented on a plurality of devices. In this case, the device may represent a system including the plurality of devices and the interconnect to enable data exchange between the plurality of devices.

In a preferred embodiment, the one or more interfaces are configured to connect the device to the data source to retrieve the values. An interface may refer to a software or hardware component that may allow communication between different systems, devices, or applications. In the context of connecting a device to a database to retrieve values, one or more interfaces can be configured to establish a connection between the device and the database and to facilitate the exchange of information. The one or more interfaces may be configured to specify the communication protocols, data formats, and other parameters that govern the interaction between the device and the database. It is to be understood that any other kind of data source can be used, such as a machine learning system or any other kind of knowledge based, implemented in hardware and/or as a software component(s). The interfaces can also provide an abstraction layer that allows the device to access the data source in a way that is independent of the underlying data source technology, making it easier to switch to a different data source system in the future if necessary. Interfaces can be designed to be flexible and scalable to accommodate changes in the data source structure and to support high performance data transfers, ensuring that the device can retrieve values from the data source in an efficient and reliable manner.

According to another embodiment, the one or more interfaces are configured to obtain the one or more 3D models. The one or more interfaces may be specifically designed to retrieve the 3D models from the BIM system or any other storage source. The one or more interfaces may provide a means for the device to access the 3D models stored in the BIM system, enabling the device to use the 3D models to generate a rendered 3D representation. By configuring the interfaces to obtain the 3D models, the device can efficiently and accurately retrieve the data required for the representation, reducing the need for manual data entry and increasing the reliability of the 3D representation. The use of interfaces to obtain the 3D models also allows for seamless integration with the BIM system, enabling the device to take advantage of the data and information stored in the BIM system and to keep the representation up to date as changes are made to the 3D models stored in the BIM system. The 3D models may also be stored in a location other than the BIM system. In this case, the one or more interfaces could be configured to connect the device to the alternate storage location and retrieve the 3D models from there. This alternate storage location could be a local file system, a cloud-based storage solution, or any other type of data storage accessible by the device. The key is that the one or more interfaces could be configured to access and retrieve the 3D models from the alternate storage location in a manner consistent with the requirements of the device and processing according to embodiments of the present disclosure. By using an alternate storage location, the 3D models can be managed and stored in a manner that meets the specific needs of the organization, while still allowing the device to use the 3D models to generate the rendered 3D representation.

In a further embodiment, the device is a GIS device. The GIS device may be specifically designed to work with structures and geographic data and information. In this case, the device would be able to use the 3D models obtained through the one or more interfaces to generate a rendered 3D representation of the structures and/or the geographic data, allowing users to visualize and analyze the combined 3D representations of the one or more parameters for the grid cells in relation to the geographic information in a more interactive and intuitive manner. The GIS device could also use the 3D models to support a variety of GIS-based analysis and visualization tasks, such as spatial analysis, route optimization, and terrain modeling. By incorporating the 3D models into the GIS, the GIS device could provide a more complete and accurate representation of the structures, their properties, corresponding values, parameters, and other information in the 3D representations in relation to the geographic information, thereby enabling more informed decision making related to technical parameters of the environment.

A third aspect of the disclosure defines a system, comprising a device; a data source storing values; and a network configured to link the device and the data source. The device is configured to perform a method according to an embodiment of the first aspect. In particular, the device can be configured to provide a grid including a plurality of grid cells, each grid cell designating an area of a surface; obtain one or more models of one or more structures, each structure being positioned in at least one of the areas designated by the grid cells of the grid; identify properties of components of the one or more structures in each of the one or more models; retrieve values for the properties from a data source; for each grid cell, identify components of the one or more structures in the one or more models positioned in the respective grid cell, retrieve the properties of the identified components, and calculate one or more parameters for the respective grid cell using the retrieved properties and the corresponding values; generate one or more combined representations of the one or more parameters for the grid cells; render a representation of the surface and of the one or more combined representations, each positioned at the respective grid cell on the surface; and enable interaction with at least a part of the one or more combined representations of the one or more parameters.

A fourth aspect of the disclosure defines a computer-readable medium, at least one computer-readable medium, one or more computer-readable media or a plurality of computer-readable media storing instructions thereon that, when executed by a computing device, configure the computing device to perform a method according to an embodiment of the first aspect of the present disclosure. In particular, the method may comprise providing a grid including a plurality of grid cells, each grid cell designating an area of a surface; obtaining one or more models of one or more structures, each structure being positioned in at least one of the areas designated by the grid cells of the grid; identifying properties of components of the one or more structures in each of the one or more models; retrieving values for the properties from a data source; for each grid cell, identifying components of the one or more structures in the one or more models positioned in the respective grid cell, retrieving the properties of the identified components, and calculating one or more parameters for the respective grid cell using the retrieved properties and the corresponding values; generating one or more combined representations of the one or more parameters for the grid cells; rendering a representation of the surface and of the one or more combined representations, each positioned at the respective grid cell on the surface; and enabling interaction with at least a part of the one or more combined representations of the one or more parameters.

Embodiments of the present disclosure refer to analysis and exploitation of (physical) structures placed in an (physical) environment using a computing device. The physical structures are represented as (digital) models, which may include geometric elements that reflect the form and shape of components of the physical structure, and which further specify (physical) properties of the components of the structures. The geometry may be segmented into (digital) segments or groups according to the grid and grid cells. The segments may be processed by a computing device to calculate parameters for the grid cells, to provide an interactive rendered representation of parameters, structures, and the environment, which enables an improved configuration of the environment with regard to physical properties within the environment. It is to be understood that the present disclosure may refer to processing of (digital) segments with regard to (physical) areas on the surface. The skilled person would understand that processing of the (digital) segments with regard to the (physical) areas of the surface involves digital models of the physical structures. For any physical entity involved in the digital processing according to an embodiment of the present disclosure, the disclosure implies (and results in) physical processing based on the (digital) models of the physical entity.

It is to be understood that embodiments of the device or system according to the second and third aspect may include logic, processor(s), or one or more functional unit(s) that may be configured according to processing steps of the method of an embodiment of the first aspect of the disclosure, in any combination. Likewise, the method according to embodiments of the first aspect may include processing steps reflecting a functional configuration of the structural features of the device or system, in any combination.

### BRIEF DESCRIPTION OF THE DRAWINGS

Specific features, aspects, and advantages of the disclosure will be better understood with regard to the following description and accompanying drawings where:
- Figure 1: illustrates a flow chart of a method according to an embodiment of the present disclosure;
- Figure 2: illustrates a flow chart of a method according to an embodiment of the present disclosure;
- Figure 3: shows a rendering of a combined representation according to one embodiment of the present disclosure;
- Figures 4A and 4B: illustrate a segmentation of a structure based on a grid according to an embodiment of the present disclosure;
- Figure 5: illustrates a structure positioned on a grid according to an embodiment of the present disclosure;
- Figures 6A and 6B: show renderings of representations according to an embodiment of the present disclosure; and
- Figure 7: displays a flow chart of a method according to an embodiment of the present disclosure.

### DETAILED DESCRIPTION

In the following description, reference is made to drawings which illustrate various embodiments. Various embodiments will also be described below by reference to several examples. It is to be understood that the embodiments may include changes in design and structure without departing from the scope of the claimed subject matter.

The techniques described herein may be implemented in various computing systems, examples of which are described in more detail below. Such systems generally involve the use of suitably configured computing devices that implement a number of modules, each of which provides one or more operations necessary to complete the execution of such techniques. Each module may be implemented in a unique manner; they need not all be implemented in the same manner. As used herein, a module may be a structural component of a system that performs an operational role, which may be a portion or an entire software element (e.g., a function of a process, a discrete process, or any other suitable embodiment). A module may comprise computer-executable instructions and may be encoded on a computer storage medium. Modules may be executed in parallel or serially, as appropriate, and may pass information between each other using shared memory on the computer on which they are executed, using a message passing protocol, or in any other suitable manner. Exemplary modules performing one or more tasks are described below, although it should be appreciated that the modules and task partitioning described are merely illustrative of the type of modules that may implement the exemplary techniques described herein, and that the invention is not limited to being implemented in any particular number, partitioning, or type of modules. In some implementations, all of the functionality may be implemented in a single module. Further, for clarity, the modules are discussed below as all executing on a single computing device, although it should be appreciated that in some implementations, the modules may be implemented on separate computing devices adapted to communicate with each other. In particular, the modules may be implemented on a device for processing simulated sensor data, on a host system, or in a simulator environment according to one or more embodiments of the present disclosure, in any combination.

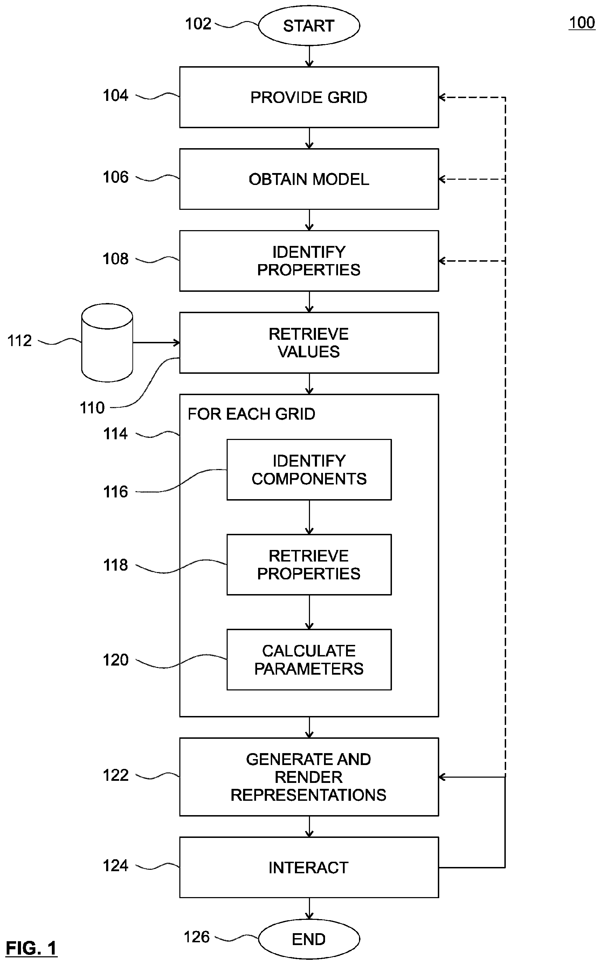

Figure 1 illustrates a flow chart of a method according to an embodiment of the present disclosure. The method 100 may be a computer-implemented method. The method 100 may comprise a plurality of steps, items and/or processing steps, each of which may reflect one or more instructions executable by at least one processor to configure the at least one processor (or a corresponding at least one computing device) to at least partially perform processing as identified in the respective step, item and/or processing step of the method 100.

The method 100 may begin at item 102 and proceed to item 104, wherein a grid may be provided including a plurality of grid cells, each grid cell designating an area of a surface. Thus, the grid may also be referred to as a surface grid. The surface may be located in an environment. In item 106, one or more three-dimensional (3D) models of one or more structures may be obtained. Each structure may be positioned in at least one of the areas designated by the grid cells of the grid. In item 108, properties of components of the one or more structures may be identified in each of the one or more 3D models. In item 110, the method 100 may access a data source 112, such as a database or knowledge base system, to retrieve values for the properties from the data source.

Processing of the method 100 may continue for each grid cell in item 114. In particular, for each grid cell, which may be the current grid cell, components of the one or more structures in the one or more 3D models positioned in the current grid cell may be identified in item 116. Corresponding properties of the identified components may be retrieved in item 118 to calculate one or more parameters for the current grid cell using the retrieved properties and corresponding values in item 120. The processing of item 114 may be repeated with a next grid cell until all grid cells have been processed. It is to be understood that the processing of item 114 may be performed on grid cells containing structures and/or routes. Empty grid cells need not to be processed and may be omitted.

The processing of the method 100 may continue with item 122, wherein one or more combined 3D representations of the one or more parameters for the grid cells may be generated and subsequently rendered. In particular, rendering may include rendering a 3D representation of the surface and the one or more combined 3D representations, each positioned at the respective grid cell on the surface.

The method 100 may proceed to item 124, which may enable interaction with at least a portion of the one or more combined 3D representations of the one or more parameters. The interaction in item 124 may result in an adjustment of the rendered representation(s), such as by changing a perspective, and the method may proceed with item 122. In addition, the interaction in item 124 may enable an adjustment of properties, in which case the method 100 may proceed with item 108. In addition or as an alternative, the interaction in item 124 may allow a modification of the structures and/or paths in the environment, in which case the paths may be rerouted and/or the structures may be adjusted, and the processing may proceed with item 106. According to a further interaction possibility, the grid or a grid spacing may be adjusted, which may lead to a continuation of the processing in item 104.

The method 100 may end in item 126.

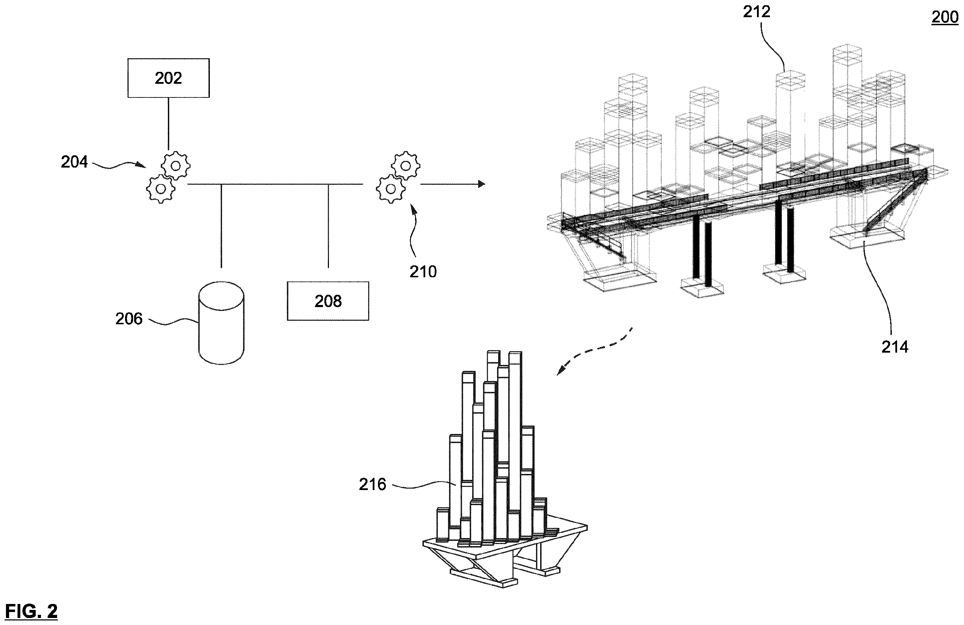

Figure 2 illustrates a flow chart of a method according to an embodiment of the present disclosure. The method 200 may, at least partially, correspond to the method 100 as shown in Figure 1, or may provide alternative or additional details and aspects.

The method 200 may start with retrieving or loading of models 202. The models 202 can be 3D models. The models 202 may be retrieved from a Building Information Modeling (BIM) system. The models 202 may be Industry Foundation Classes (IFC) models. IFC models are digital building models, which can be used, for example, in the construction and building industry. IFC models are a standardized file format for exchanging information about a building's design and construction, including architectural, structural, MEP (Mechanical, Electrical, and Plumbing), and other building systems information. IFC models provide a common platform for exchanging information and enable collaboration between stakeholders and integration of data from different design software and systems.

The models 202 can be processed in item 204. This may include geometry processing of structures defined in the model and/or semantic processing of data included in the model, such properties of the structures specified in the model and data identifying interrelations between the structures and/or components.

The properties could be used to access the data source 206 in order to retrieve values for the properties. The data source 206 may be an ecological or eco database including ecological values. This may include, for example, ecological values related to materials specified in the models 202.

Subsequently or in parallel to the retrieval of the models 202 and/or to the retrieval of values from the data source 206, environmental data 208 may be retrieved. The environmental data 208 may specify the environment in which the structures defined in the models 202 are located. The environmental data 208 may be data from a geographic information systems (GIS). GIS may store and manage spatial data, which includes data that can be tied to a specific location on the Earth's surface, and non-spatial data characterizing the environment. This can include map layers with data, such as, maps, aerial photos, and/or satellite imagery that show the physical features and characteristics of the Earth's surface; geographical points, lines, and polygons, which may represent geographic features such as buildings, roads, rivers, and parks, as well as boundaries such as city limits, political boundaries, and watersheds; attribute data, which may be tied to a specific location on the Earth's surface, such as the name of a building, the population of a city, or the type of land use in a particular area; demographic data including data related to population, such as age, gender, income, and education level; further environmental characteristics, such as air and water quality, land use, and natural resources; infrastructure data, which may include data related to the built environment, such as roads, bridges, and utilities; and/or historical data, which may include data related to events or conditions that occurred in the past, such as past land use, historical aerial photos, and past climate data, to name a few, in any combination.

In item 210, the structures in models 202, the values in data source 206, and the environmental data 208 may be used to define placement of the structures in the environment, connections of the structures by one or more infrastructure routes in the environment (preferably on the surface of the environment), and the impact of the structures (and of the infrastructure) on the environment and interaction with the environment. This processing is based on a grid structure that designates areas of the surface in the environment. For each grid cell of the grid structure, components of structures or infrastructure (routes) positioned in the grid cell may be identified in order to calculate parameters for the grid cell using properties of the structures or infrastructure in the grid cell and corresponding values 206.

This may be used to generate a combined representation 212 of the parameters for the grid cells which can be combined with a representation 214 of a corresponding structure(s). The example shown in Figure 2 may refer to a bridge structure (railroad overpass). The maximum area of the overpass may be, for example, approximately 28 meters by 13 meters. However, any other size can be used and this is an example only. The materials used in the construction of the overpass can include ready-mixed concrete C20/25, reinforcing steel, bitumen, ECB plastic roofing membrane, hot-dip galvanized steel sheet, and/or elastomeric waterstops, to name a few, in any combination. In one example, the volume of ready-mixed concrete may be approximately 117 cubic meters, while the volume of the reinforcing steel may be approximately 2 cubic meters. The remaining materials may each have a volume of less than 1 cubic meter. In one example, the global warming potential (GWP) for the entire construction process, including stages of including material production, material transport, and construction, may be approximately 1,400 metric tons of CO2-equivalent. This value represents the estimated amount of greenhouse gases emitted during the construction process and is a measure of the project's impact on the environment.

The parameters calculated for each grid cell may indicate contributions of the different stages of the bridge's construction, including material production, material transport, and construction, which can be displayed as a stacked bar chart. A stacked bar chart can be used to visually represent the different stages of the construction process and their respective impact on the environment, which may include, for example, their contributions to the GWP. Each stage, such as material production, material transport, and construction, could be represented by a separate portion of a single bar in the chart. The height of each portion could represent the corresponding parameter, such as the global warming potential, with the portion for the stage with the highest parameter being the tallest. For example, if the GWP for material production is 500 tCO2-eq, material transport is 300 tCO2-eq, and construction is 600 tCO2-eq, the chart would show a single bar with three portions, with the portion for construction being the tallest. The portions could be stacked on top of each other. The stacked bar chart provides a way to visualize the different contributions of each stage and to compare the impact of each stage on the environment. It makes it easier to understand and analyze the data, as well as to identify areas for improvement in terms of reducing the environmental impact of construction processes.

Even though the representation 212 in Figure 2 represents a stacked bar chart, it is to be understood that any other representation technique could be used to display the parameters in order to visualize the impact of the structures and/or routes in each grid cell on the environment.

The representations 212 and 214 may be rendered as a three-dimensional interactive visualization 216 that may enable interaction with the individual representations, changes of perspective, changes in rendering style, and the like, in any combination.

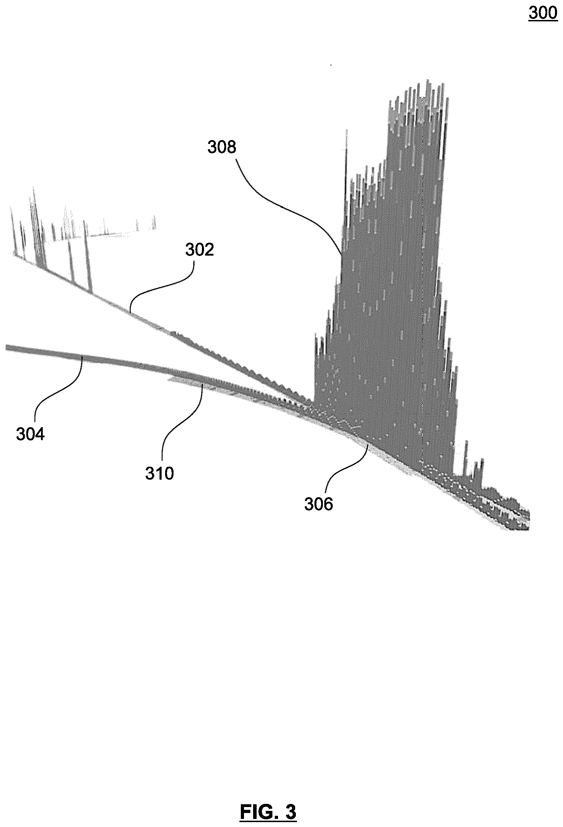

An example of a rendering of a combined representation according to one embodiment of the present disclosure is shown in Figure 3. The rendering 300 may be generated, at least partially, by the method 100 as shown in Figure 1 and/or the method 200 as shown in Figure 2, in any combination.

The rendering 300 may show two routes 302 and 304 at a junction 306. The structures and routes may be analyzed according to, for example, method 100 of Figure 1 and/or method 200 of Figure 2, in order to automatically generate combined representations of parameters of grid cells that may indicate, for example, and impact of each grid cell on the environment. Similar to the representation 216 in Figure 2, the combined representations may be displayed as a stacked bar chart. Lower bar charts may indicate a relatively low impact on the environment. Higher bar charts may indicate a relatively high impact on the environment. Accordingly, the rendering 300 may be used to identify areas with a high potential for optimization, such as, area 308, and/or areas with a low potential for optimization, such as, area 310.

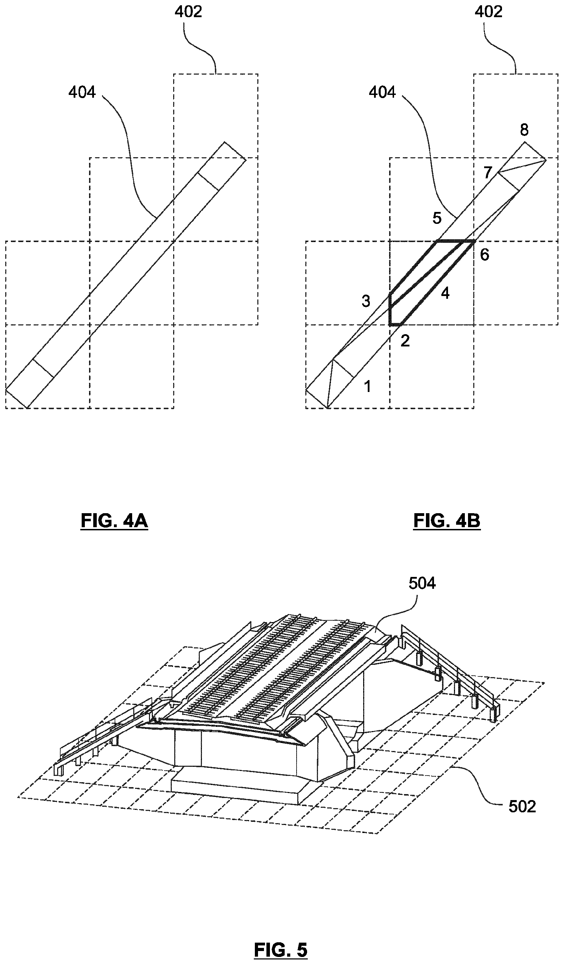

Figures 4A and 4B illustrate a segmentation of a structure based on a grid according to an embodiment of the present disclosure. The segmentation and/or the grid may, at least partially, be applicable to or a result of the method 100 as shown in Figure 1 and/or the method 200 as shown in Figure 2, in any combination. Figures 4A and 4B show a grid 402 and a top view of at least one structure 404. The grid 402 may designate a surface and the structure(s) 404 may be positioned in relation to the surface, such as on, under or above the surface.

The structure(s) 404 may be segmented along the boundaries of the grid cells of the grid 402. Segmenting may include cutting the geometry of each of the structures 404 into multiple parts. For example, the geometry may be represented as a triangle mesh or as a mesh or set of any other kind of (interrelated) geometric primitives. To segment the geometry, mesh partitioning or mesh segmentation could be used. This process divides the mesh into smaller, nonoverlapping sub-meshes, or segments, while preserving the overall topology and geometry of the mesh. This may result in a plurality of partial structures or sub structures with individual or inherited parameters of the base model of the structure 404, as indicated by numerals 1 to 8 in Figure 4B. The partial structures or sub structures may be grouped in each grid cell, such that the grid cell forms a basis for subsequent individual analysis to derive the parameters of each grid cell with respect to the included partial structures or sub-structures (or parts of routes, if any).

Positioning of structures within grid cells defines a foreign key for analyzing properties of the structures, which may be defined in various models using various parameters. Grid cells can define universal tiles in order to define a georeferenced geometry base. This enables a versatile solution for capturing and mapping spatial information. The grid may provide a standardized framework for representing geometries, regardless of whether they are 2D or 3D objects. This means that all kinds of spatial data can be captured and organized using the grid cells. Using the grid and by potentially adjusting a grid size, this can be used to dynamically relate, analyze and display various parameters through a common and standardized foreign key. The foreign key can be used to draw connections between different types of data, allowing for a deeper understanding of the underlying relationships and patterns in the different models or structures and their impact on the environment. The grid, which may be also referred to as Universal Tiles (as a georeferenced geometry base), may be a flexible and efficient way of capturing and representing spatial information for various models in an environment, and exploiting their impact on the environment. The foreign key also enables dynamic analysis and display of related parameters, making it a powerful tool for gaining a deeper understanding of complex spatial relationships.

The parameters of the partial structures or sub-structures may be provided in a data format, which may, for example, include a header with basic information, and table part with a grid cell (or tile) identification and a list of parameters (or attributes), e.g. Tile ID; AttributeA; [AttributeN]. Only grid cells which include parameters or attributes must be stored and data for empty grid cells can be omitted.

Figure 5 illustrates a structure positioned on a grid according to an embodiment of the present disclosure. A grid 502 may designate an area, which may include a structure 504 or multiple structures. The structure(s) 504 may be applicable, at least partially, to the method 100 as shown in Figure 1 and/or the method 200 as shown in Figure 2, in any combination. The structure(s) 504 may be segmented using the grid 502 as illustrated in Figures 4A and 4B.

The grid 502 may be any kind of standardized grid. The grid 502 may be or correspond to, for example, a Universal Transverse Mercator (UTM) coordinate reference system that is used to map and locate positions on the Earth's surface. This may include the UTM32 grid. The UTM system divides the Earth's surface into 60 zones, each 6 degrees of longitude wide, with the prime meridian (0° longitude) as the central line. UTM32 refers to the 32nd of these zones, which covers an area stretching from approximately 6°E to 12°E longitude. In UTM32, coordinates are given in meters east (Easting) and north (Northing) of a specified origin, which is defined as the intersection of the equator and the central meridian of the UTM zone. The use of UTM coordinates provides a consistent, accurate, and efficient way to describe the location of a point on the Earth's surface and to perform spatial analysis and mapping.

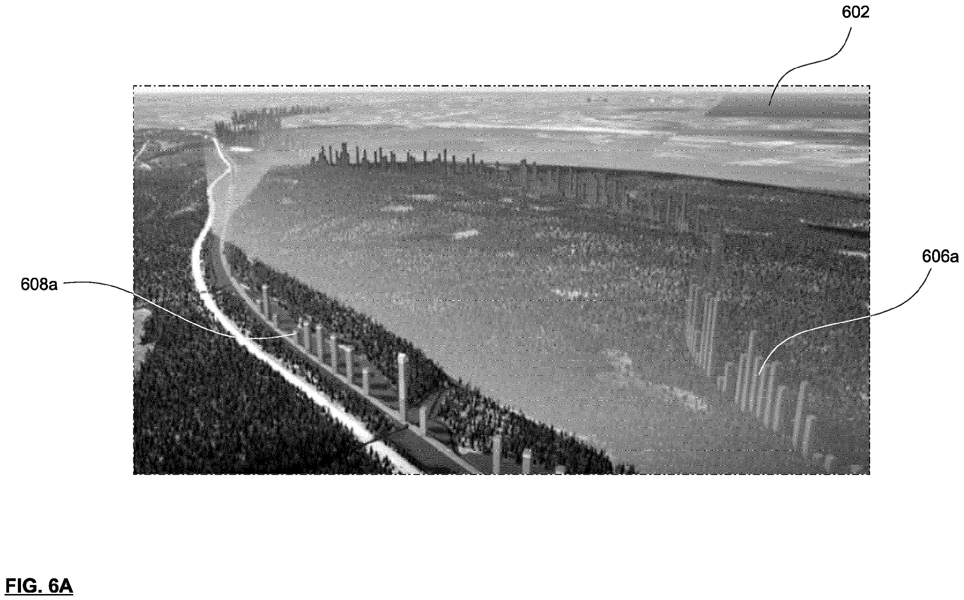

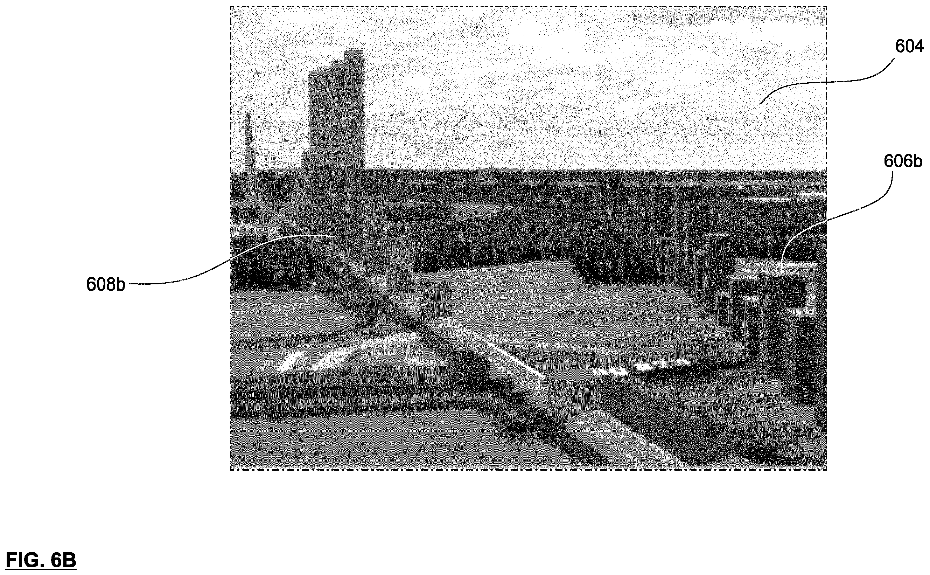

Figures 6A and 6B show renderings of representations according to an embodiment of the present disclosure. The renderings 602, 604 may be generated, at least partially, by the method 100 as shown in Figure 1 and/or the method 200 as shown in Figure 2, in any combination. The renderings 602, 604 may be, at least partially a result of the segmentation as illustrated in Figures 4A and 4B. The renderings 602, 604 may show representation of routes and structures, which may be overlaid on a graphical visualization of a surface of the earth. The renderings 602, 604 may further include a representation of alternatives 606a, 606b to existing routes 608a, 608b in the respective environments. The visualizations may enable a direct comparison of the impact of new routes and/or new structures planned for an environment.

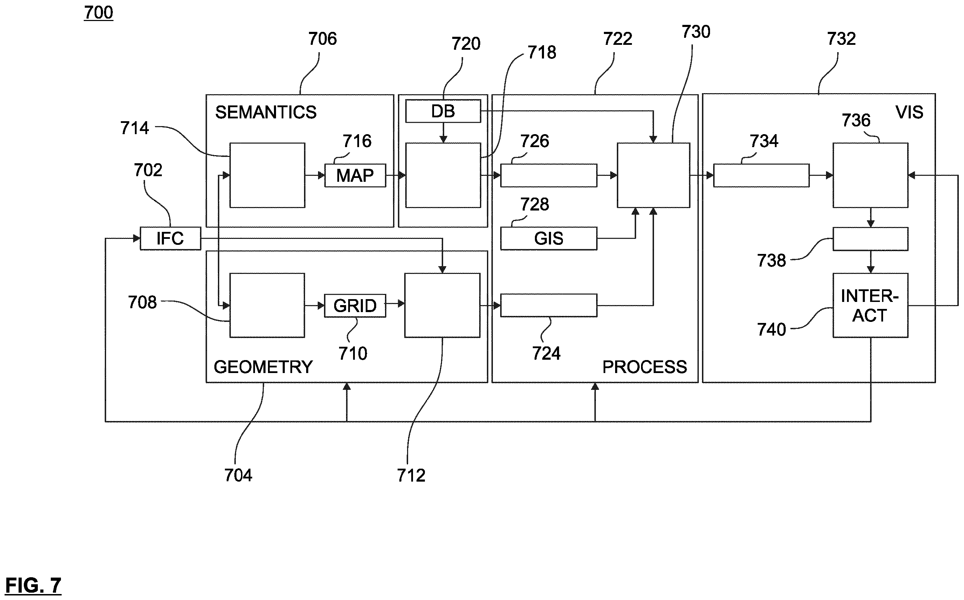

Figure 7 displays a flow chart of a method according to an embodiment of the present disclosure. The method 700 may, at least partially, correspond to the method 100 as shown in Figure 1 and/or the method 200 as shown in Figure 2, in any combination. The method 700 may further detail aspects of the methods 100 and/or 200.

The method 700 may start with retrieving or loading of IFC models 702. The models 702 are used for geometry processing in item 704, and semantic processing in item 706. The geometry processing 704 provides or generates a grid 708 and associates tile ID is with grid cells in item 710. Subsequently, the IFC models 702 our segmented in item 712. This may include calculation of volumes of sub- structures or partial structures in the respective grid cells. The semantic processing 706 may include generation of mapping tables with keys or strings for parameters of or attributes specified in the retrieved IFC models 702, in item 714. The resulting mapping tables 716 may be used in item 718 to retrieve values for the parameters according to the mapping tables 7 and at 16 from a data source 720, for example an database including ecological or environmental values.

The grid-based structures as generated by item 712, results of the mapping of item 718, and values retrieved from the data source 720 may be supplied to block 722 to determine parameters for the individual grid cells which may reflect the impact of structures (or routes) in the respective grid cells on the environment. In detail, the grid-based structures as generated by item 712 may be arranged as an information grid 724 according to a data format, for example, specifying one or more of a tile identification, model information, volume calculation referring to the respective grid cell, and respective parameters or attributes for the incorrect cell, in any combination.

The results of the mapping of item 718 may result in a mapping table 726, which may be completed with values retrieved from the data source 720.

Processing in block 722 may further take into account GIS information 728, which may include, for example, routes or other infrastructure elements or interconnections within the environment.

Values from the data source 720, the completed mapping tables 726, the GIS information 728, and the information grid 724 may be taken into considered for calculations of parameters for individual grid cells and generation of the combined representations in item 730.

The information may be visualized in box 732. The rendering and visualization may be based on the combined representations 734, which may be, for example, represented as a Global Warming Potential (GWP) data model. The combined representations 734 may be rendered 736, enriched overlaid with further geometry information or data in item 738 and provided to an interactive visualization environment 740.

The interaction in the interactive visualization environment 740 may have an impact on any stage of the processing of the method 700. For example, the interaction may lead to an updated or changed visualization in item 736. Further, the interaction could have an impact on the IFC models 702, on the geometry processing 704, for example, by changing the size of the grid cells, or on the processing in block 722, in any combination.

The method 700 is not restricted to particular type of data or type of models. Rather, any kind of models, data, or information can be provided. The grid 710 is applied to segment the various types of models. Further to the IFC models 702 (with visualization in 3D), the method 700 and other aspects or embodiments of the present disclosure can be applied to, for example, designation of wind suitability areas (2D), which can involve a dynamic (on the fly) filtering of distance rules and further criteria for spatial planning; spatial resistance analyses (3D), which can include individual assessments of protected assets visualized in 3D as a whole; route finding for infrastructure projects (2D), which can include aspects of spatial resistance and other relevant aspects, such as slopes in a dashboard with filters, in order to identify suitable areas for routes on the fly. Further application areas of embodiments of the present disclosure may include applications related to policing, risk prediction, weather forecasts, to name a few, in any combination.

It is to be understood that the implementational details as provided in Figures 1 to 7 represent preferred examples. Other implementations using different components, modules, blocks, units, circuitry, connections, and links can be used, and the present disclosure is not restricted by a particular implementation or illustrated application area.

While some embodiments have been described in detail, it is to be understood that aspects of the disclosure can take many forms. In particular, the claimed subject matter may be practiced or implemented differently from the examples described, and the described features and characteristics may be practiced or implemented in any combination. The embodiments shown herein are intended to illustrate rather than to limit the invention as defined by the claims.

## Claims

1. A computer-implemented method, comprising:
providing a grid including a plurality of grid cells, each grid cell designating an area of a surface;
obtaining one or more models of one or more structures, each structure being positioned in at least one of the areas designated by the grid cells of the grid;
identifying properties of components of the one or more structures in each of the one or more models;
retrieving values for the properties from a data source;
for each grid cell, identifying components of the one or more structures in the one or more models positioned in the respective grid cell, retrieving the properties of the identified components, and calculating one or more parameters for the respective grid cell using the retrieved properties and the corresponding values;
generating one or more combined representations of the one or more parameters for the grid cells;
rendering a representation of the surface and of the one or more combined representations, each positioned at the respective grid cell on the surface; and
enabling interaction with at least a part of the one or more combined representations of the one or more parameters.

2. The method of claim 1, further comprising retrieving the one or more models from a Building Information Modeling (BIM) system.

3. The method of claim 1 or 2, further comprising determining whether a model spans a plurality of grid cells, and if the model spans a plurality of grid cells, segmenting the model into partial models along boundaries of the grid cells, and determining the properties of components of the one or more structures in the partial models.

4. The method according to any one of the preceding claims, wherein the properties include a volume of the corresponding component for each grid cell.

5. The method according to any one of the preceding claims, wherein the properties include material properties of components of the structure.

6. The method according to any one of the preceding claims, wherein the properties include one or more identifications of materials of components of the structure, the method further comprising using the one or more identifications to retrieve the values from the data source.

7. The method according to any one of the preceding claims, further comprising adjusting at least one property of at least one component, retrieving values for the adjusted at least one property, and re-calculating the one or more parameters for grid cells including the at least one component.

8. The method according to any one of the preceding claims, wherein the values include sustainability values.

9. The method according to any one of the preceding claims, further comprising adjusting a grid size of the grid cells and re-calculating the one or more parameters for the grid cells with the adjusted grid size.

10. The method according to any one of the preceding claims, further comprising, responsive to the interaction with the combined representations, overlaying the rendered representation of the surface and of the one or more combined representations with a representation of the one or more parameters.

11. The method according to any one of the preceding claims, further comprising analyzing the one or more parameters and identifying structures with potential for optimization.

12. The method according to any one of the preceding claims, wherein the one or more parameters define one or more of a spatio-structural impact, technical impact, and environmental impact of a route and/or structure in the respective grid cell.

13. The method according to any one of the preceding claims, further comprising providing the rendered representation and the parameters in a Geographic Information System (GIS).

14. At least one computer-readable medium storing instructions thereon that, when executed on a computing device, configure the computing device to perform a method according to any one of the preceding claims.

15. An electronic device, comprising:
a display; and
a processor configured to perform a method according to any one of the claims 1 to 13.
